# EUROPÄISCHE PATENTSCHRIFT

(11) **EP 3 015 995 B1**
(45) Veröffentlichungstag und Bekanntmachung des Hinweises auf die Patenterteilung: **08.03.2017**
(21) Anmeldenummer: 15193577.2
(22) Anmeldetag: 09.11.2015
(51) Int. Cl.: G06F 15/78, G06F 9/44

(54) **VERFAHREN ZUM KONFIGURIEREN EINER SCHNITTSTELLENEINHEIT EINES COMPUTERSYSTEMS**
METHOD FOR CONFIGURING AN INTERFACE UNIT OF A COMPUTER SYSTEM
PROCEDE DE CONFIGURATION D'UNE UNITE D'INTERFACE D'UN SYSTEME INFORMATIQUE

(30) Priorität: 11.05.2015 DE 102015107296; 11.05.2015 DE 102015107299
(43) Veröffentlichungstag der Anmeldung: 04.05.2016
(73) Patentinhaber: dSPACE digital signal processing and control engineering GmbH, 33102 Paderborn (DE)
(72) Erfinder: Sauer, Jochen, 33034 Brakel (DE); Leinfellner, Robert, 33098 Paderborn (DE); Klemm, Matthias, 33102 Paderborn (DE); Brehm, Thorsten, 33102 Paderborn (DE); Polnau, Robert, 33098 Paderborn (DE); Schmitz, Matthias, 33102 Paderborn (DE)

(56) Entgegenhaltungen:
- EP-A1- 2 799 983
- RAMONA DUELKS ET AL: "A Real-Time Test and Simulation Environment Based on Standard FPGA Hardware", TESTING: ACADEMIC AND INDUSTRIAL CONFERENCE - PRACTICE AND RESEARCH TECHNIQUES, 2009. TAIC PART '09, IEEE, PISCATAWAY, NJ, USA, 4. September 2009 (2009-09-04), Seiten 197-204, XP031611115, ISBN: 978-0-7695-3820-4
- "Auf zu schnelleren Zeiten", , 1. Juni 2012 (2012-06-01), XP055124881, Gefunden im Internet: URL:http://www.dspace.com/shared/data/pdf/ 2012/Magazin_42_45_Schnelle_Zeiten_D.pdf [gefunden am 2014-06-24]
- "Wenn sich Prozessor und FPGA ergänzen", , 1. Mai 2011 (2011-05-01), XP055124886, Gefunden im Internet: URL:http://www.dspace.com/shared/data/pdf/ 2011/503_dSpace_Ek_auto_2011-05_lowres_pdf .pdf [gefunden am 2014-06-24]

## Beschreibung

Gegenstände der im Folgenden beschriebenen Erfindung sind ein Verfahren zum Konfigurieren einer Schnittstelleneinheit eines Computersystems gemäß dem Oberbegriff des Patentanspruchs 1 sowie ein Computersystem gemäß dem Oberbegriff des Patentanspruchs 12.

Viele Computersysteme weisen Schnittstelleneinheiten für den Datenaustausch zwischen einem Hauptprozessor und peripheren Geräten auf. Eine derartige Schnittstelleneinheit kann beispielsweise als steckbare I/O-Karte ausgestaltet sein. Viele Schnittstelleneinheiten sind mit eigenen Prozessoren zur Aufbereitung ein- und auslaufender Daten ausgestattet, wobei es einige Schnittstelleneinheiten ermöglichen, die Programmierung des auf der Schnittstelleneinheit hinterlegten Prozessors flexibel den Anforderungen des durch den Hauptprozessor abgearbeiteten Programms anzupassen.

Beispielsweise bietet die Firma Digi International Inc. unter dem Produktnamen RabbitCore RCM4100 eine durch den Anwender frei programmierbare Schnittstelleneinheit an. Ein anderer bekannter Ansatz ist, eine Vielzahl von Programmfunktionalitäten für die Aufbereitung ein- und auslaufender Daten persistent auf der Schnittstelleneinheit zu hinterlegen. Einen derartigen Ansatz beschreibt beispielsweise die Druckschrift US 6.189.052 B2. Die Patentanmeldung EP 2.799.983 A1 beschreibt die Verwendung eines FPGAs als Schnittstelleneinheit zwischen I/O-Kanälen eines Computersystems und einem Prozessor des Computersystems und die flexible Programmierung des FPGAs hinsichtlich seiner Funktion als Schnittstelleneinheit gemäß den Anforderungen eines auf dem Computersystem hinterlegten Computerprogramms.

Wenn das Computersystem vorgesehen ist, das durch den Hauptprozessor abgearbeitete Programm in harter Echtzeit abzuarbeiten, dann müssen die auf dem Computersystem ablaufenden Prozesse, insbesondere auch die durch den auf der Schnittstelleneinheit hinterlegten Prozessor abgearbeiteten Prozesse, innerhalb eines vordefinierten Zeitraums garantiert abgeschlossen werden. Der Prozessor auf der Schnittstelleneinheit sollte deshalb effizient arbeiten, d.h. ein möglichst großer Anteil der durch ihn ausgeführten Prozessorbefehle sollte zielführend mit der programmgemäßen Aufbereitung ein- und auslaufender Daten verknüpft sein. Weiterhin sollte der auf der Schnittstelleneinheit hinterlegte Prozessor möglichst deterministisch arbeiten, also einen geringen Jitter aufweisen, sodass die für die Abarbeitung von Prozessen benötigte Zeit hinreichend gut abschätzbar ist.

Vor diesem Hintergrund ist es Aufgabe der Erfindung, ein den Stand der Technik erweiterndes Verfahren zum Konfigurieren einer Schnittstelleneinheit eines Computersystems anzugeben, das eine schnelle und jitterarme Abarbeitung des auf einem Prozessor oder mehreren Prozessoren der Schnittstelleneinheit hinterlegten Programmcodes zur Aufarbeitung von zwischen einem Hauptprozessor und einer Peripherie des Computersystems ausgetauschten Daten gewährleistet.

Die Aufgabe wird durch ein Verfahren mit den Merkmalen des Patentanspruchs 1 gelöst. Vorteilhafte Ausgestaltungen der Erfindung sind Gegenstand von abhängigen Ansprüchen.

Gegenstand der Erfindung ist demnach ein Verfahren zum Konfigurieren einer Schnittstelleneinheit eines Computersystems, wobei das Computersystem einen ersten Prozessor und eine erste Datenverbindung zwischen dem ersten Prozessor und der Schnittstelleneinheit aufweist und auf der Schnittstelleneinheit ein zweiter Prozessor hinterlegt ist oder hinterlegt wird. Die Schnittstelleneinheit weist mindestens zwei Datenkanäle auf, wobei ein erster Eingangsdatenkanal als Datenkanal zum Hinterlegen von Eingangsdaten und ein erster Ausgangsdatenkanal als Datenkanal zum Hinterlegen von Ausgangsdaten ausgestaltet ist. Weiterhin wird eine Peripherie des Computersystems derart eingerichtet, dass die Peripherie eine Anzahl peripherer Geräte umfasst und die Peripherie ausgestaltet ist, um mittels einer zweiten Datenverbindung Eingangsdaten in dem ersten Eingangsdatenkanal zu hinterlegen oder Ausgangsdaten aus dem ersten Ausgangsdatenkanal auszulesen. Die Schnittstelleneinheit ist ausgestaltet, um eine Datenverbindung zum Auslesen der in dem ersten Eingangsdatenkanal hinterlegten Eingangsdaten durch den zweiten Prozessor bereitzustellen und um eine Datenverbindung zum Hinterlegen von Ausgangsdaten in dem ersten Ausgangsdatenkanal durch den zweiten Prozessor bereitzustellen. Auf dem Computersystem wird ein Computerprogramm hinterlegt, und der erste Prozessor wird programmiert, um das Computerprogramm abzuarbeiten und während der Abarbeitung des Computerprogramms einer Variablen des Computerprogramms einen Wert zuzuweisen, der durch die im ersten Eingangsdatenkanal hinterlegten Eingangsdaten definiert ist.

Erfindungsgemäß ist vorgesehen, dass vor Beginn der Abarbeitung des Computerprogramms durch den ersten Prozessor (CN) durch das Computersystem (HIL) eine Konfigurationsphase gestartet wird und während der Konfigurationsphase von dem Computersystem (HIL) eine Sequenz von Prozessorbefehlen erstellt und auf den zweiten Prozessor geladen wird, nach dem Laden der Sequenz auf den zweiten Prozessor die Abarbeitung des Computerprogramms durch den ersten Prozessor und die Abarbeitung der Sequenz durch den zweiten Prozessor gestartet wird und während der Abarbeitung der Sequenz der durch die im ersten Eingangsdatenkanal hinterlegten Daten definierte Wert an eine erste Speicheradresse geschrieben wird. Die Erstellung der Sequenz von Prozessorbefehlen erfolgt derart, dass eine Anzahl von Subsequenzen von Prozessorbefehlen erstellt wird, wobei eine erste Subsequenz eine Routine zum Einlesen und Verarbeiten zumindest der in dem ersten Eingangsdatenkanal hinterlegten Daten darstellt und eine zweite Subsequenz eine Routine zum Einlesen und Verarbeiten zumindest der in einem zweiten Eingangsdatenkanal hinterlegten Daten darstellt oder eine Routine zur Verarbeitung von durch den ersten Prozessor erzeugten Daten und zur Hinterlegung der verarbeiteten Daten in dem ersten Ausgangsdatenkanal darstellt, und durch Zusammenfügen der Subsequenzen die Sequenz erstellt wird.

Unter einer Subsequenz ist in einer Ausführung des erfindungsgemäßen Verfahrens eine Folge von durch den zweiten Prozessor ausführbaren Prozessorbefehlen zu verstehen, die in ihrer Gesamtheit eine Routine zur Weiterleitung von Eingangsdaten bilden, d.h. eine Routine zum Auslesen der Eingangsdaten aus einem Eingangsdatenkanal und zur Hinterlegung der ausgelesenen Eingangsdaten an einer durch den ersten Prozessor auslesbaren Speicheradresse, oder die in ihrer Gesamtheit eine Routine zur Weiterleitung von Ausgangsdaten bilden, d.h. eine Routine zum Auslesen der Ausgangsdaten aus einer durch den ersten Prozessor beschreibbaren Speicheradresse und zur Hinterlegung der ausgelesenen Ausgangsdaten in einem Ausgangsdatenkanal. In einer anderen Ausführung des erfindungsgemäßen Verfahrens ist unter einer Subsequenz zusätzlich eine Information zu verstehen, die in eindeutiger Weise eine durch den zweiten Prozessor ausführbare Folge von Prozessorbefehlen definiert, wobei die durch die Subsequenz definierten Prozessorbefehle in ihrer Gesamtheit jeweils eine Routine zur Weiterleitung von Eingangsdaten oder von Ausgangsdaten bilden. In der letztgenannten Ausführung liegt jede Subsequenz zunächst in Form einer derartigen Information vor und wird vor dem Laden der Sequenz auf den zweiten Prozessor in eine Folge von durch den zweiten Prozessor ausführbaren Prozessorbefehlen übersetzt. Insbesondere liegt in einer Ausführung der Erfindung jede Subsequenz zunächst in Form von durch einen Prozessor des Computersystems automatisch in einer Hochsprache verfassten Quellcodes vor, wobei vor dem Laden der Sequenz auf den zweiten Prozessor jede Subsequenz für den zweiten Prozessor kompiliert wird.

Eingangsdaten und Ausgangsdaten können von einer Sequenz in unveränderter Form weitergeleitet werden. Eine Sequenz kann aber auch Prozessorbefehle beinhalten, um eingelesene Daten aufzubereiten oder zu verarbeiten und die eingelesenen Daten in aufbereiteter oder verarbeiteter Form weiterzuleiten.

Unter einer Sequenz ist erfindungsgemäß eine durch Zusammenfügen von Subsequenzen erstellte Folge von Subsequenzen zu verstehen, unabhängig davon, ob die Subsequenzen als eine Folge von durch den zweiten Prozessor ausführbaren Prozessorbefehlen vorliegen oder in Form einer eine Folge von Prozessorbefehlen definierenden Information vorliegen.

Unter Eingangsdaten werden von einer peripheren Komponente des Computersystems erzeugte, zur Verarbeitung durch das durch den Hauptprozessor abgearbeitete Computerprogramm vorgesehene Daten verstanden. Beispiele für Eingangsdaten sind Messwerte eines Sensors oder einer in eine automotive Simulation eingebundenen Echtlast. Ein Eingangsdatenkanal ist ein zur Hinterlegung von Eingangsdaten durch eine periphere Komponente eingerichteter Datenkanal der Schnittstelleneinheit. Unter Ausgangsdaten werden von dem Computerprogramm erzeugte, zur Auslesung durch eine periphere Komponente vorgesehene Daten verstanden. Beispiele für Ausgangsdaten sind Steuerbefehle für einen Aktor einer in eine automotive Simulation eingebundenen Echtlast. Ein Ausgangsdatenkanal ist ein zur Hinterlegung von Ausgangsdaten zur Auslesung durch eine periphere Komponente eingerichteter Datenkanal der Schnittstelleneinheit.

Ein Vorteil des erfindungsgemäßen Verfahrens ist, dass die durch den zweiten Prozessor abgearbeitete Routine zur Verarbeitung von Eingangsdaten und Ausgangsdaten auf dem ersten Prozessor erstellt wird, der auch mit der Abarbeitung des Computerprogramms beaufschlagt ist. Dazu ist vorgesehen, dass unterschiedliche Subroutinen des Computerprogramms, die während der Abarbeitung des Computerprogramms Daten mit der Peripherie austauschen, jeweils eine eigene, den Anforderungen der jeweiligen Subroutine entsprechende Subsequenz erstellen. Die auf den zweiten Prozessor geladene Sequenz ist dadurch immer den individuellen Anforderungen des auf dem ersten Prozessor hinterlegten Computerprogramms angepasst. Dadurch entfällt die Notwendigkeit, eine große Anzahl von Funktionalitäten zur Aufbereitung, Verarbeitung und Weiterleitung von Daten persistent auf dem zweiten Prozessor vorzuhalten. Während der Abarbeitung des Computerprogramms arbeitet der zweite Prozessor die Sequenz sukzessive ab, d.h. führt die in der Sequenz enthaltenen Prozessorbefehle in der erhaltenen Reihenfolge aus, und investiert wenig Rechenkapazität, insbesondere keine Rechenkapazität, in die Ausführung unproduktiver, d.h. nicht unmittelbar zielführender, Prozessorbefehle wie Sprunganweisungen und Funktionsaufrufe. Weiterhin entfällt die Notwendigkeit prozessorseitiger Optimierungsvorkehrungen zur Beschleunigung der Abarbeitung des auf dem zweiten Prozessor hinterlegten Programmcodes, beispielsweise durch Caching, wodurch eine deterministische Abarbeitung der Sequenz durch den zweiten Prozessor sichergestellt ist.

Ein weiterer Vorteil der Erfindung ist eine Kostenreduktion gegenüber aus dem Stand der Technik bekannten Lösungen. Weil der zweite Prozessor die Sequenz von Prozessorbefehlen nur sukzessive abarbeiten muss, ist eine hinreichend schnelle Abarbeitung der Sequenz auch bei Anwendung eines technisch einfachen, kostengünstigen Prozessors auf der Schnittstelleneinheit gewährleistet.

Bevorzugt beinhaltet das Computerprogramm mindestens einen ersten I/O-Treiber und einen zweiten I/O-Treiber, wobei der erste I/O-Treiber die erste Subsequenz erstellt und der zweite I/O-Treiber die zweite Subsequenz erstellt. Unter einem I/O-Treiber ist im Rahmen der Erfindung eine Subroutine einer Task des Computerprogramms zu verstehen, wobei der I/O-Treiber eine Subroutine für den Austausch von Daten zwischen der Task und der Peripherie beinhaltet.

Besonders bevorzugt wird vor Beginn der Abarbeitung des Computerprogramms eine Konfigurationsphase des Computersystems gestartet, wobei während der Konfigurationsphase eine Softwareinstanz die Sequenz erzeugt, wobei die Sequenz unmittelbar nach Erzeugung durch die Softwareinstanz leer ist, also noch keine Prozessorbefehle und noch keine einen Prozessorbefehl definierende Information enthält, und wobei der erste I/O-Treiber die erste Subsequenz in die Sequenz schreibt und der zweite I/O-Treiber die zweite Subsequenz in die Sequenz schreibt. In dieser Ausführung erzeugt die Softwareinstanz die Sequenz als ein Objekt, das eigerichtet ist, eine Anzahl an Subsequenzen aufzunehmen.

In einer bevorzugten Ausführung wird die Sequenz vor dem Laden der Sequenz auf den zweiten Prozessor von einer Softwareinstanz automatisch optimiert. Unter einer Optimierung der Sequenz ist insbesondere die Bereinigung der Sequenz von redundanten Prozessorbefehlen zu verstehen, beispielsweise durch Entfernung redundanter Prozessorbefehle oder durch Einfügung eines Befehls zur Ausführung eines Strobes. Wegen der voneinander unabhängigen Erstellung der einzelnen Subsequenzen sind redundante Prozessorbefehle in der noch nicht optimierten Sequenz nicht auszuschließen.

Unter einem Strobe ist zu verstehen, dass mindestens zwei Prozessorbefehle zur Ausgabe eines Datums, d.h. mindestens ein erster Prozessorbefehl und ein zweiter Prozessorbefehl zum Schreiben eines Wertes in eine Speicheradresse, nicht unmittelbar nach Aufruf des jeweiligen Prozessorbefehls durch den zweiten Prozessor durchgeführt werden, sondern der gemäß dem ersten Prozessorbefehl zu schreibende erste Wert und der gemäß dem zweiten Prozessorbefehl zu schreibende zweite Wert zunächst archiviert werden, und dass bei Ausführung des Strobes durch den zweiten Prozessor der erste Wert und der zweite Wert simultan oder unmittelbar nacheinander geschrieben werden. Ein Strobe bewirkt somit eine Synchronisierung der Ausgabe von Daten einer Sequenz.

Besonders bevorzugt erfolgt die Erstellung der Subsequenzen derart, dass die Sequenz eine minimierte Anzahl an Sprunganweisungen, insbesondere keine Sprunganweisungen, aufweist. Weiterhin bevorzugt erfolgt die Erstellung der Subsequenzen derart, dass die Sequenz keine Funktionsaufrufe beinhaltet.

Weiterhin bevorzugt ist der zweite Prozessor eingerichtet oder wird eingerichtet, bei der Abarbeitung der Sequenz kein Caching anzuwenden, sodass die zur Abarbeitung der Sequenz benötigte Zeit sich in eindeutiger Weise aus der Anzahl der in der Sequenz enthaltenen Prozessorbefehle und aus der Taktung des zweiten Prozessors ergibt.

In einer vorteilhaften Ausgestaltung des Verfahrens weist die Schnittstelleneinheit mindestens zwei parallel arbeitende zweite Prozessoren auf, wobei für jeden zweiten Prozessor eine individuelle Sequenz erstellt wird. Unter einem zweiten Prozessor ist in dieser Ausführung jeder auf der Schnittstelleneinheit hinterlegte Prozessor zu verstehen, der die in einem der in den Ansprüchen 1 bis 6 beanspruchten Verfahren definierten Eigenschaften des zweiten Prozessors aufweist und der vorgesehen ist, eine gemäß einem der in den Ansprüchen 1 bis 6 beanspruchten Verfahren erstellte Sequenz von Prozessorbefehlen abzuarbeiten.

Besonders bevorzugt weist die Schnittstelleneinheit ein FPGA auf, und die auf der Schnittstelleneinheit hinterlegten zweiten Prozessoren sind oder werden als Softcores auf dem FPGA implementiert, insbesondere derart, dass die Softcores als Flow-Control-Prozessoren implementiert sind bzw. werden.

In einer vorteilhaften Ausgestaltung des Verfahrens beinhaltet das Computerprogramm mehr als eine Task, und jeder zweite Prozessor wird eindeutig einer Task zugewiesen, wobei die auf einen bestimmten zweiten Prozessor geladene Sequenz nur Subsequenzen von I/O-Treibern der Task enthält, der der bestimmte Prozessor zugewiesen ist.

Bevorzugt wird weiterhin jeder Task mit mindestens einem I/O-Treiber eine Priorität zugewiesen, und die zweiten Prozessoren werden bevorzugt der Task mit der höchsten Priorität zugewiesen.

In einer weiterhin bevorzugten Ausgestaltung wird die Abarbeitung der Sequenz auf einem zweiten Prozessor durch ein Triggersignal gestartet, wobei ein zweiter Prozessor die Sequenz nach Registrierung eines Triggersignals durch den zweiten Prozessor genau einmal abarbeitet. Das Triggersignal wird dabei durch einen I/O-Treiber oder zu vordefinierten Zeitpunkten durch einen Zeitgeber, d.h. einen Timer, erzeugt.

Gegenstand der Erfindung ist außerdem ein Computersystem mit einem ersten Prozessor und einer Schnittstelleneinheit mit einem auf der Schnittstelleneinheit hinterlegten zweiten Prozessor, das eingerichtet ist, um mittels des ersten Prozessors ein durch einen der Ansprüche 1 bis 11 beanspruchtes Verfahren zum Konfigurieren der Schnittstelleneinheit durchzuführen. Bevorzugt ist das Computersystem ausgestaltet, um ein Computerprogramm mittels des ersten Prozessors in harter Echtzeit abzuarbeiten, insbesondere wobei das Computersystem als Hardware-in-the-Loop-Simulator oder als Rapid-Control-Prototyping-System ausgestaltet ist.

Unter einem Hardware-in-the-Loop-Simulator ist im Zusammenhang der Erfindung insbesondere ein Computersystem zu verstehen, das eingerichtet und vorgesehen ist, um mit den Dateneingängen und Datenausgängen eines eigebetteten Systems, beispielsweise eines elektronischen Steuergeräts oder einer mechatronischen Komponente, verbunden zu werden, und das weiterhin eingerichtet ist, insbesondere auch hinsichtlich der in dem Computersystem verbauten Hardware eingerichtet ist, um die reale Umgebung des eingebetteten Systems in harter Echtzeit zu simulieren.

Unter einem Rapid-Control-Prototyping-System ist im Zusammenhang der Erfindung insbesondere ein tragbares Computersystem zu verstehen, das eingerichtet und vorgesehen ist, in ein Netzwerk elektronischer Steuergeräte eingebunden zu werden, beispielsweise in einem Automobil, in dem Netzwerk vorübergehend die Aufgabe eines elektronischen Steuergeräts zu übernehmen und in harter Echtzeit Daten mit elektronischen Steuergeräten auszutauschen, Daten von Sensoren einzulesen und Aktoren anzusteuern.

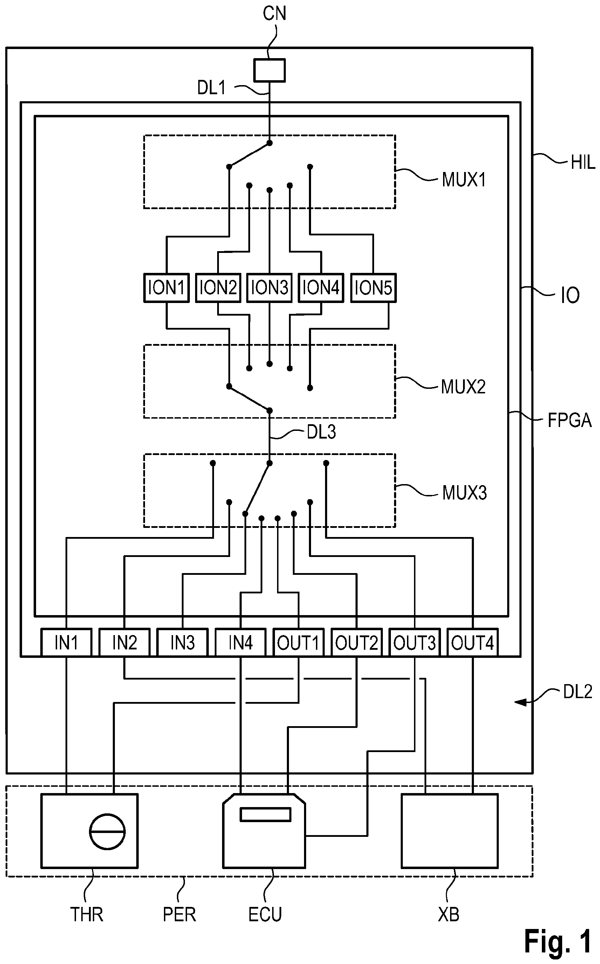

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigen
- Figur 1: eine schematische Ansicht eines zur Durchführung des erfindungsgemäßen Verfahrens ausgebildeten Computersystems,
- Figur 2: eine Darstellung von Verfahrensschritten zur Erstellung einer Sequenz von Prozessorbefehlen und
- Figur 3: eine Darstellung der Erstellung mehrerer Sequenzen durch den ersten Prozessor und deren Verteilung auf mehrere zweite Prozessoren.

Die Abbildung der Figur zeigt eine schematische Darstellung eines als Hardware-in-the-Loop-Simulators, kurz HIL, ausgestalteten Computersystems HIL. Das Computersystem HIL weist einen ersten Prozessor CN und eine als steckbare I/O-Karte ausgestaltete Schnittstelleneinheit IO auf, und zwischen dem ersten Prozessor CN und der Schnittstelleneinheit IO ist eine serielle erste Datenverbindung DL1 eingerichtet. Das Computersystem HIL ist eingerichtet, um mittels des ersten Prozessors CN ein Computerprogramm zur Simulation einer Umgebung eines elektronischen Steuergerätes ECU, beispielsweise eines automotiven Steuergerätes zum Testen der Software des Steuergerätes ECU, in harter Echtzeit abzuarbeiten.

Auf der Schnittstelleneinheit IO ist ein FPGA verbaut, und die Schnittstelleneinheit weist acht Datenkanäle auf, davon vier Eingangsdatenkanäle IN1, ..., IN4 und vier Ausgangsdatenkanäle OUT1, ..., OUT4. Auf dem FPGA sind als zweite Prozessoren fünf Schnittstellenprozessoren ION1, ..., ION5 hinterlegt, die als sogenannte Softcores in die logische Schaltung des FPGAs programmiert sind.

Der Begriff Schnittstellenprozessor wird im Folgenden synonym zu dem Begriff "zweiter Prozessor" gemäß den Patentansprüchen verwendet. Der Begriff Schnittstellenprozessor wird ausschließlich zum Zweck der besseren Lesbarkeit der nachfolgenden Erläuterungen verwendet und beinhaltet für sich genommen keine technischen Spezifikationen, sofern diese nicht ausdrücklich angegeben sind.

Die Implementierung eines Softcores in einer programmierbaren logischen Schaltung, beispielsweise eines FPGAs, ist dem Fachmann aus dem Stand der Technik bekannt. Die fünf Schnittstellenprozessoren ION1, ..., ION5 sind identisch implementiert und als Flow-Control-Prozessoren (FCPs) ausgestaltet, d.h. ihre Bauweise und ihr Befehlssatz sind für die Weiterleitung, Aufbereitung und Verarbeitung von Eingangsdaten und Ausgangsdaten optimiert. Jeder einzelne der Schnittstellenprozessoren ION1, ..., ION5 verfügt nur über einen Rechenkern und ist ausgestaltet und vorgesehen, um eine Sequenz von Prozessorbefehlen sukzessive abzuarbeiten. Insbesondere verfügen die Schnittstellenprozessoren ION1, ..., ION5 über keine Vorrichtungen zur Beschleunigung der Abarbeitung einer Befehlssequenz, wie sie viele Prozessoren aufweisen, beispielsweise Caching oder Parallelisierung durch mehrere Rechenkerne. Untersuchungen haben gezeigt, dass es möglich ist, acht derart einfach ausgestaltete FCPs als Softcores auf einem FPGA zu implementieren.

In einer bevorzugten Ausgestaltung sind die Schnittstellenprozessoren ION1, ..., ION5 nicht persistent auf dem FPGA hinterlegt, sondern sind als Kompilat auf einem Flash-Speicher des Computersystems HIL hinterlegt und werden in einer Konfigurationsphase des Computersystems HIL vor Beginn der Abarbeitung des Computerprogramms in die logische Schaltung des FPGAs programmiert, wobei die Schnittstellenprozessoren ION1, ..., ION5 als unprogrammierte Prozessoren hinterlegt werden, d.h. auf den Schnittstellenprozessoren ION1, ..., ION5 sind zunächst keine Prozessorbefehle hinterlegt.

Die Schnittstelleneinheit IO ist über eine zweite Datenverbindung DL2 mit einer Peripherie PER verbunden. Die Peripherie PER beinhaltet drei periphere Komponenten: eine Echtlast THR, ein elektronisches Steuergerät ECU und eine Erweiterungsbox XB. Die zweite Datenverbindung DL2 ist als eine Vielzahl von Kabelverbindungen eingerichtet, die zwischen den peripheren Komponenten THR, ECU, XB der Peripherie PER und den Datenkanälen IN1, ..., IN4, OUT1, ..., OUT4 der Schnittstelleneinheit IO verlegt sind. Die Echtlast THR ist beispielsweise eine Drosselklappe eines Automobils. Da das Computerprogramm nicht in der Lage ist, eine Drosselklappe zu simulieren, ist die Drosselklappe als physische Komponente in die Simulation eingebunden. Der erste Prozessor CN erzeugt nach den Vorgaben des Computerprogramms ein Steuersignal für einen Aktor der Echtlast THR, und das Steuersignal wird über einen Datenausgang OUT1 der Schnittstelleneinheit IO an den Aktor übertragen. Ein Sensor der Echtlast THR wird über einen Dateneingang IN1 der Schnittstelleneinheit IO ausgelesen und das ausgelesene Sensorsignal durch den ersten Prozessor CN anhand der Vorgaben des Computerprogramms verwertet.

Das elektronische Steuergerät ECU ist ein physisches Steuergerät, beispielsweise ein automotives Steuergerät, das in die Simulation eingebunden ist, um die auf dem elektronischen Steuergerät ECU hinterlegte Software auf korrekte Funktion zu überprüfen. Dazu simuliert der erste Prozessor CN in harter Echtzeit die Umgebung des elektronischen Steuergerätes, insbesondere weitere elektronische Steuergeräte, Sensoren, Aktoren und Fahrmanöver des simulierten Fahrzeugs, und tauscht dazu mit dem elektronischen Steuergerät ECU Daten aus. Das elektronische Steuergerät ist eingerichtet, um aus zwei Ausgangsdatenkanälen OUT2, OUT3 der Schnittstelleneinheit IO durch den ersten Prozessor CN erzeugte Ausgangsdaten einzulesen, und es ist eingerichtet, um in einem Eingangsdatenkanal IN4 durch das elektronische Steuergerät erzeugte Eingangsdaten zur Verwertung durch den ersten Prozessor CN zu hinterlegen, beispielsweise ein Steuersignal für eine durch den ersten Prozessor CN simulierte Komponente.

Die Erweiterungsbox XB enthält weitere, dem ersten Prozessor CN bei der Abarbeitung des Computerprogramms assistierende Computerkomponenten in Form steckbarer Leiterplatten. Die Erweiterungsbox XB ist eingerichtet, um Ausgangsdaten aus einem Ausgangsdatenkanal OUT4 einzulesen und Eingangsdaten in einem Eingangsdatenkanal IN2 zu hinterlegen.

Die Schnittstellenprozessoren ION1, ..., ION5 sind über einen in die logische Schaltung des FPGAs programmierten, durch einen nicht dargestellten ersten Arbiter angesteuerten ersten Multiplexer MUX1 mit der ersten Datenverbindung DL1 verbunden, und der erste Arbiter ist eingerichtet, mittels des ersten Multiplexers MUX1 dem ersten Prozessor CN Zugriff auf genau einen Schnittstellenprozessor ION1, ..., ION5 zu gewähren. Die Schnittstellenprozessoren ION1, ..., ION5 sind weiterhin über einen Demultiplexer MUX2 sowie einen zweiten Multiplexer MUX3 mit den Datenkanälen IN1, ..., IN4, OUT1, ..., OUT4 verbunden, und ein nicht dargestellter zweiter Arbiter ist eingerichtet, um einem der Schnittstellenprozessoren ION1, ..., ION5 mittels Ansteuerung des Demultiplexers MUX2 und des zweiten Multiplexers MUX3 Zugriff auf einen der Datenkanäle IN1, ..., IN4, OUT1, ..., OUT4 zu gewähren.

In jedem der vier Eingangsdatenkanäle IN1, ..., IN4 ist ein nicht dargestellter Prozessor hinterlegt, der eingerichtet ist, um ein Eingangsdatum von einer peripheren Komponente der Peripherie PER aufzunehmen und das Eingangsdatum einem der Schnittstellenprozessoren ION1, ..., ION4 zum Auslesen zur Verfügung zu stellen. In jedem der vier Ausgangsdatenkanäle OUT1, ..., OUT4 ist ein nicht dargestellter Prozessor hinterlegt, der eingerichtet ist, um ein Ausgangsdatum von einem der Schnittstellenprozessoren ION1, ..., ION5 aufzunehmen und einer peripheren Komponente der Peripherie PER zum Auslesen zur Verfügung zu stellen.

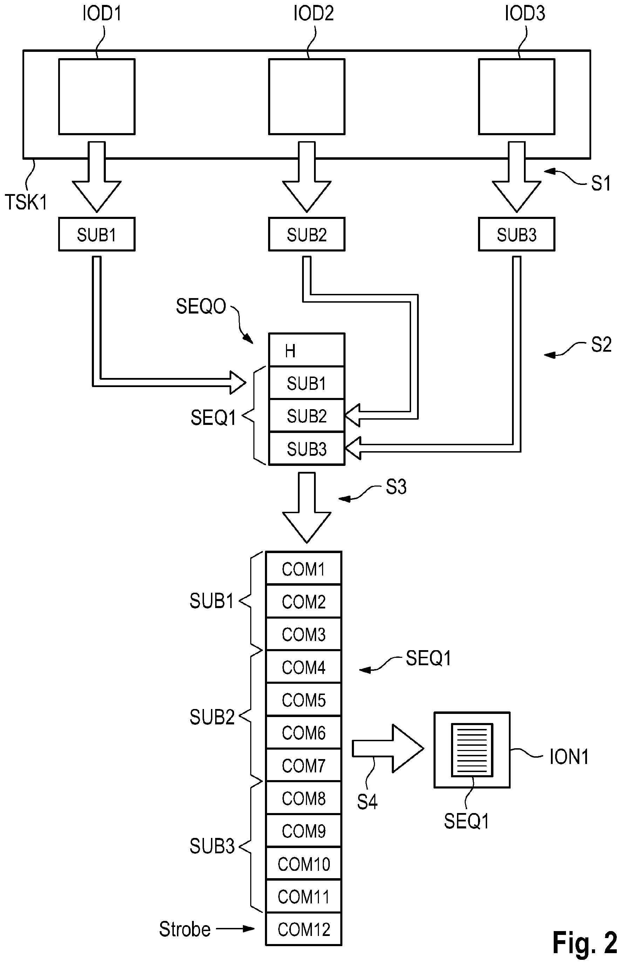

Die Abbildung der Figur 2 zeigt Verfahrensschritte zur Erstellung einer Sequenz von Prozessorbefehlen für einen Schnittstellenprozessor ION1 in einer bevorzugten Ausführung des erfindungsgemäßen Verfahrens. Eine erste Task TSK1 des auf dem ersten Prozessor CN hinterlegten Computerprogramms beinhaltet einen ersten I/O-Treiber IOD1, einen zweiten I/O-Treiber IOD2 und einen dritten I/O-Treiber IOD3. In einem ersten Verfahrensschritt S1 erstellt jeder I/O-Treiber IOD1, IOD2, IOD3 der ersten Task TSK1 eine Subsequenz zur Abarbeitung durch den Schnittstellenprozessor ION1. Der erste I/O-Treiber IOD1 erstellt eine erste Subsequenz SUB1 , der zweite I/O-Treiber IOD2 erstellt eine zweite Subsequenz SUB2 , und der dritte I/O-Treiber IOD3 erstellt eine dritte Subsequenz SUB3.

Die erste Subsequenz SUB1, die zweite Subsequenz SUB2 und die dritte Subsequenz SUB3 stellen jeweils eine Routine zur Weiterleitung von in einem Eingangsdatenkanal hinterlegten Eingangsdaten zur Hinterlegung an einer durch den ersten Prozessor CN auslesbaren Speicheradresse oder zur Weiterleitung von durch den ersten Prozessor CN erzeugten Ausgangsdaten zur Hinterlegung in einem Ausgangsdatenkanal dar. Die Subsequenzen SUB1, SUB2, SUB3 enthalten keine Funktionsaufrufe.

Die erste Subsequenz SUB1, die zweite Subsequenz SUB2 und die dritte Subsequenz SUB3 liegen nach Durchführung des ersten Verfahrensschritts in Form einer Abfolge von in einer Hochsprache formulierten Programmbefehlen vor, beispielsweise einer Abfolge von C++-Befehlen. Jede Subsequenz SUB1, SUB2, SUB3 enthält mindestens einen Programmbefehl zur Weiterleitung eines Eingangsdatums oder eines Ausgangsdatums, beispielsweise einen Befehl aus der Familie der *memcpy-*Befehle, wie sie in der Sprache C++ definiert sind. Ein Beispiel ist der Befehl *memcpy32,* dessen Syntax in der einfachsten Form wie folgt ist:
memcpy32(add2, add1, n);

Der Befehl liest, beginnend an der Speicheradresse add1, eine Anzahl von n Daten der Wortlänge 32 Bit ein und schreibt die Daten an die Speicheradresse add2. Wenn der Befehl zur Weiterleitung eines Eingangsdatums vorgesehen ist, dann ist add1 eine Speicheradresse in einem Eingangsdatenkanal, also eine Speicheradresse, die durch den in einem Eingangsdatenkanal hinterlegten Prozessor beschreibbar und auslesbar ist, und add2 ist eine durch den ersten Prozessor CN auslesbare Speicheradresse. Wenn der Befehl zur Weiterleitung eines Ausgangsdatums vorgesehen ist, dann ist add1 eine durch den ersten Prozessor CN beschreibbare Speicheradresse, und add2 ist eine Speicheradresse in einem Ausgangsdatenkanal, also eine Speicheradresse, die durch den in einem Ausgangsdatenkanal hinterlegten Prozessor beschreibbar und auslesbar ist. Jeder I/O-Treiber IOD1, ..., IOD3 erstellt die memcpy32-Befehle mit relativen Speicheradressen als Werte für add1 und add2 in Relation zu einer innerhalb des jeweiligen I/O-Treibers IOD1, ..., IOD3 als null definierten Speicheradresse.

Jede Subsequenz SUB1, SUB2, SUB3 wird anhand der Anforderungen der Task TSK1, in die der jeweilige I/O-Treiber eingebunden ist, sowie anhand von durch einen Anwender definierten Konfigurationsdaten automatisch erstellt und ist jeweils an die individuellen Anforderungen der Task TSK1 angepasst. In einer beispielhaften Anwendung ist der erste I/O-Treiber IOD1 vorgesehen, um an einem Eingangsdatenkanal IN1 ein Steuersignal für eine Pulsweitenmodulation eines Aktorsignals auszulesen, und ein Anwender kann mittels einer Konfigurationssoftware festlegen, ob nur der Tastgrad des Aktorsignals moduliert werden soll oder ob der Tastgrad und die Frequenz des Aktorsignals moduliert werden sollen. Im ersten Fall schreibt der erste I/O-Treiber IOD1 nur einen memcpy32-Befehl zur Weiterleitung eines Sollwerts für den Tastgrad in die erste Subsequenz SUB1. Im zweiten Fall schreibt der erste I/O-Treiber IOD1 zwei memcpy32-Befehle in die erste Subsequenz SUB1, einen zur Weiterleitung eines Sollwerts für den Tastgrad und einen zur Weiterleitung eines Sollwerts für die Frequenz. Der erste I/O-Treiber IOD1 kann eine Subsequenz SUB1 derart erstellen, dass sie ausschließlich einen oder mehrere memcpy32-Befehle enthält. Der erste I/O-Treiber IOD1 kann optional neben einer Anzahl von memcpy32-Befehlen auch weitere Programmbefehle zur Aufbereitung oder Verarbeitung der Eingangsdaten in die erste Subsequenz SUB1 schreiben.

Analog besteht jede Subsequenz SUB1, ..., SUB3 zumindest aus einer Anzahl von memcpy32-Befehlen, kann aber optional weitere Programmbefehle zur Aufbereitung oder Verarbeitung von Eingangsdaten oder Ausgangsdaten aufweisen, beispielsweise Programmbefehle, um Eingangsdaten oder Ausgangsdaten zu skalieren oder mit einem Gleichanteil zu versehen.

In einem zweiten Verfahrensschritt S2 werden die Subsequenzen SUB1, SUB2, SUB3 zu einer Sequenz SEQ1 zusammengefügt. Dazu erstellt eine Softwareinstanz zunächst ein Softwareobjekt SEQO. Das Softwareobjekt SEQO enthält ein Kopfdatenfeld H mit Informationen über den ersten I/O-Treiber IOD1, den zweiten I/O-Treiber IOD2 und den dritten I/O-Treiber IOD3, und das Softwareobjekt SEQO ist eingerichtet, um eine Anzahl von in einer Hochsprache formulierten Subsequenzen SUB1, ..., SUB3 aufzunehmen und zu speichern. Die I/O-Treiber der ersten Task TSK1 schreiben dann nacheinander ihre jeweiligen Subsequenzen SUB1, ..., SUB3 in das Softwareobjekt SEQO, d.h. zuerst schreibt der erste I/O-Treiber IOD1 die erste Subsequenz SUB1 in das Softwareobjekt SEQO, danach schreibt der zweite I/O-Treiber IOD2 die zweite Subsequenz SUB2 in das Softwareobjekt SEQO hinter die erste Subsequenz SUB1, danach schreibt der dritte I/O-Treiber IOD3 die dritte Subsequenz SUB3 in das Softwareobjekt SEQO hinter die zweite Subsequenz SUB2. Das Softwareobjekt SEQO beinhaltet jetzt das Kopfdatenfeld H und eine erste Sequenz SEQ1, zusammengefügt aus der ersten Subsequenz SUB1, der zweiten Subsequenz SUB2 und der dritten Subsequenz SUB3.

In einem dritten Verfahrensschritt S3 wird die Sequenz SEQ1 aufbereitet, um auf einen Schnittstellenprozessor ION1 geladen zu werden. In einer ersten Optimierung werden die relativen Speicheradressen in den memcpy32-Befehlen durch absolute Speicheradressen ersetzt, wobei die dazu nötigen Informationen dem Kopfdatenfeld H entnommen werden, und die erste Sequenz SEQ1 wird um einen Befehl zur Ausführung eines Strobes ergänzt. Nach Abschluss der ersten Optimierung wird die erste Sequenz SEQ1 in eine durch einen Schnittstellenprozessor ION1 lesbare und ausführbare Sequenz von Prozessorbefehlen übersetzt. In einer zweiten Optimierung werden redundante Prozessorbefehle aus der ersten Sequenz SEQ1 entfernt.

Nach Abschluss des dritten Verfahrensschrittes S3 liegt die erste Sequenz SEQ1 als eine Abfolge von zwölf Prozessorbefehlen COM1, ..., COM12 vor, wobei die erste Subsequenz SUB1, die zweite Subsequenz SUB2 und die dritte Subsequenz SUB3 jeweils als zusammenhängende Abfolge von Prozessorbefehlen enthalten sind. Drei aufeinander folgende Prozessorbefehle COM1, ..., COM3 bilden die Funktionalität der ersten Subsequenz SUB1 ab, vier aufeinander folgende Prozessorbefehle COM4, ..., COM7 die Funktionalität der zweiten Subsequenz SUB2 und vier weitere aufeinander folgende Prozessorbefehle COM8, ..., COM11 die Funktionalität der dritten Subsequenz SUB3. Ein die erste Sequenz SEQ1 abschließender Strobe-Befehl COM12 bewirkt die synchrone Ausgabe der Daten der ersten Subsequenz SUB1, der zweiten Subsequenz SUB2 und der dritten Subsequenz SUB3. Die sukzessive Abarbeitung der ersten Sequenz SEQ1 durch einen zweiten Prozessor ION1 entspricht also einer sukzessiven Ausführung der ersten Subsequenz SUB1, der zweiten Subsequenz SUB2 und der dritten Subsequenz SUB3. Die erste Sequenz SEQ1 beinhaltet keine Funktionsaufrufe und keine Sprunganweisungen.

In einem vierten Verfahrensschritt S4 wird die optimierte Sequenz SEQ1 auf einen der Task TSK1 zugeordneten Schnittstellenprozessor ION1 geladen.

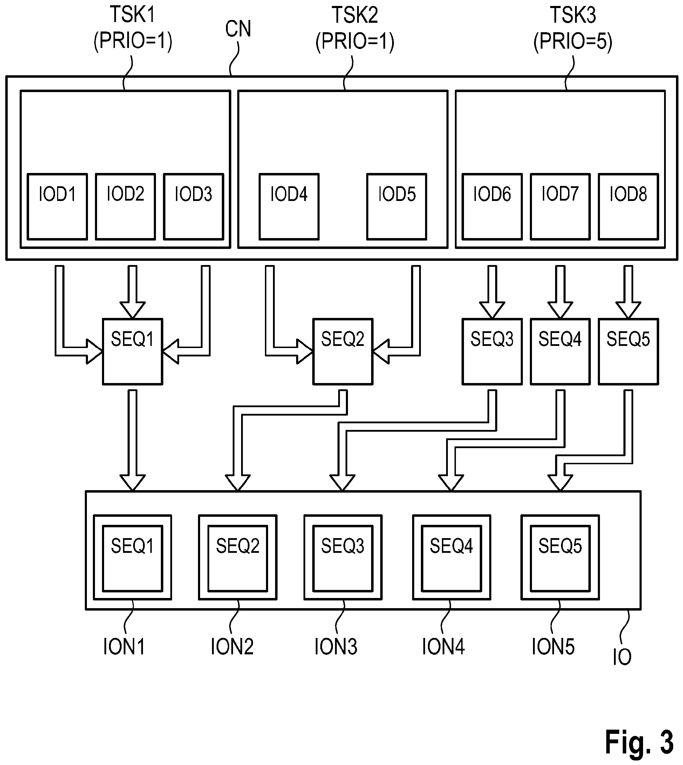

Die Abbildung der Figur 3 zeigt die erfindungsgemäße Erstellung mehrerer Sequenzen SEQ1, ..., SEQ5 und die Verteilung der Sequenzen SEQ1, ..., SEQ5 auf mehrere Schnittstellenprozessoren ION1, ..., ION5. Die Erstellung jeder Sequenz SEQ1, ..., SEQ5 erfolgt auf gleiche Weise wie die Erstellung der ersten Sequenz SEQ1, wie in der Beschreibung der Figur 2 beschrieben. In dem dargestellten Ausführungsbeispiel beinhaltet das auf dem ersten Prozessor CN hinterlegte Computerprogramm eine erste Task TSK1 mit einem ersten I/O-Treiber IOD1, einem zweiten I/O-Treiber IOD2 und einem dritten I/O-Treiber IOD3, eine zweite Task TSK2 mit einem vierten I/O-Treiber IOD4 und einem fünften I/O-Treiber IOD5, und eine dritte Task TSK3 mit einem sechsten I/O-Treiber IOD6, einem siebten I/O-Treiber IOD7 und einem achten I/O-Treiber IOD8. Der ersten Task TSK1, der zweiten Task TSK2 und der dritten Task TSK3 ist jeweils eine durch einen Parameter PRIO definierte Priorität zugewiesen, wobei der Wert von PRIO eine natürliche Zahl ist und der Wert PRIO = 1 eine Task mit geringstmöglicher Priorität kennzeichnet. Eine Softwareinstanz weist während der Konfigurationsphase jeder Task TSK1, TSK2, TSK3, die mindestens einen I/O-Treiber IOD1, ..., IOD8 aufweist, mindestens einen Schnittstellenprozessor ION1, ..., ION5 zu. Die Anzahl der auf der Schnittstelleneinheit IO hinterlegten Schnittstellenprozessoren ION1, ..., ION5 ist demnach eine obere Grenze für die Anzahl an Tasks TSK1, ..., TSK3 auf dem ersten Prozessor CN, die einrichtbar sind, um mit der Peripherie PER Daten auszutauschen, also Ausgangsdaten in einem Ausgangsdatenkanal OUT1, ..., OUT4 zu hinterlegen oder Eingangsdaten aus einem Eingangsdatenkanal IN1, ..., IN4 einzulesen. Die Softwareinstanz ist eigerichtet, hoch priorisierte Tasks bei der Zuweisung von Schnittstellenprozessoren ION1, ..., ION5 zu bevorzugen, also noch nicht zugeordnete Schnittstellenprozessoren ION1, ..., ION5 bevorzugt einer Task mit hoher Priorität zuzuweisen. Nach Abschluss der Konfigurationsphase ist jeder Schnittstellenprozessor ION1, ..., ION5 eindeutig einer Task TSK1, ..., TSK3 zugewiesen.

Der ersten Task TSK1 und der zweiten Task TSK2 ist jeweils die niedrigste Priorität zugeordnet (PRIO = 1), und beiden ist deshalb nur ein Schnittstellenprozessor ION1, ..., ION5 zugewiesen. Ein erster Schnittstellenprozessor ION1 ist der ersten Task TSK1 zugewiesen. Die I/O-Treiber der ersten Task TSK1, also der erste I/O-Treiber IOD1, der zweite I/O-Treiber IOD2 und der dritte I/O-Treiber IOD3, erstellen gemeinsam eine erste Sequenz SEQ1, d.h. die erste Sequenz SEQ1 enthält die von dem ersten I/O-Treiber IOD1, dem zweiten I/O-Treiber IOD2 und dem dritten I/O-Treiber IOD3 erstellten Subsequenzen. Ein zweiter Schnittstellenprozessor ION2 ist der zweiten Task TSK2 zugewiesen. Die I/O-Treiber der zweiten Task TSK2, also der vierte I/O-Treiber IOD4 und der fünfte I/O-Treiber IOD5, erstellen gemeinsam eine zweite Sequenz SEQ2, d.h. die zweite Sequenz SEQ2 enthält die von dem vierten I/O-Treiber IOD4 und dem fünften I/O-Treiber IOD5 erstellten Subsequenzen.

Die dritte Task TSK3 ist höher priorisiert als die erste Task TSK1 und die zweite Task TSK2, beispielsweise weil die schnelle Verarbeitung der von der dritten Task TSK3 eingelesenen Eingangsdaten von besonderer Wichtigkeit ist oder weil die dritte Task TSK3 große Mengen von Eingangsdaten verarbeitet und deshalb viele Rechenresourcen benötigt, um die von der dritten Task TSK3 eingelesenen Eingangsdaten in harter Echtzeit zu verarbeiten. Die der dritten Task zugewiesene Priorität ist PRIO = 5. Der dritten Task TSK3 sind deshalb drei Schnittstellenprozessoren ION3, ION4, ION5 zugewiesen, sodass den I/O-Treibern der dritten Task TSK3, also dem sechsten I/O-Treiber IOD6, dem siebten I/O-Treiber IOD7 und dem achten I/O-Treiber IOD8, jeweils ein eigener Schnittstellenprozessor ION1, ..., ION5 zur Hinterlegung einer Sequenz SEQ3, ..., SEQ5 zur Verfügung steht, und für jeden I/O-Treiber der dritten Task TSK3 wird eine eigene Sequenz SEQ3, ..., SEQ5 erstellt. Der sechste I/O-Treiber IOD6 erstellt eine Subsequenz und schreibt die Subsequenz in eine dritte Sequenz SEQ3. Der siebte I/O-Treiber erstellt eine Subsequenz und schreibt die Subsequenz in eine vierte Sequenz SEQ4. Der achte I/O-Treiber erstellt eine Subsequenz und schreibt die Subsequenz in eine fünfte Sequenz SEQ5. Die dritte Sequenz SEQ3, die vierte Sequenz SEQ4 und die fünfte Sequenz SEQ5 enthalten jeweils nur eine einzige Subsequenz.

Die erstellten Sequenzen SEQ1, ..., SEQ5 werden, wie in der Beschreibung der Fig. 2 beschrieben, in eine für einen Schnittstellenprozessor ION1, ..., ION5 lesbare und ausführbare Sequenz von Prozessorbefehlen umgewandelt und optimiert, und die umgewandelten und optimierten Sequenzen SEQ1, ..., SEQ5 werden auf die Schnittstellenprozessoren ION1, ..., ION5 geladen. Der erste Schnittstellenprozessor ION1 ist der ersten Task TSK1 zugewiesen, die erste Sequenz SEQ1 wird deshalb auf den ersten Schnittstellenprozessor ION1 geladen. Der zweite Schnittstellenprozessor ION2 ist der zweiten Task TSK2 zugewiesen, die zweite Sequenz SEQ2 wird deshalb auf den zweiten Schnittstellenprozessor ION2 geladen. Der dritte Schnittstellenprozessor ION3, der vierte Schnittstellenprozessor ION4 und der fünfte Schnittstellenprozessor ION5 sind jeweils der dritten Task TSK3 zugewiesen. Die dritte Sequenz SEQ3 wird auf den dritten Schnittstellenprozessor ION3, die vierte Sequenz SEQ4 auf den vierten Schnittstellenprozessor ION4 und die fünfte Sequenz SEQ5 auf den fünften Schnittstellenprozessor ION5 geladen.

Nach Abschluss der Konfigurationsphase wird die Abarbeitung des Computerprogramms durch den ersten Prozessor CN und die Abarbeitung der Sequenzen SEQ1, ..., SEQ5 durch die Schnittstellenprozessoren ION1, ..., ION5 gestartet. Die Sequenzen SEQ1, ..., SEQ5 enthalten Prozessorbefehle, um Eingangsdaten aus einem Eingangsdatenkanal IN1, ..., IN4 auszulesen, zu verarbeiten und ein Ergebnis der Verarbeitung der Eingangsdaten an eine von dem ersten Prozessor CN auslesbare Speicheradresse zu schreiben, und eine Task TSK1, ..., TSK3 liest den an der Speicheradresse hinterlegten Wert aus und weist einer Variablen des Computerprogramms anhand des an der Speicheradresse hinterlegten Wertes einen Wert zu. Die Sequenzen SEQ1, ..., SEQ5 enthalten weiterhin Prozessorbefehle, um Werte von einer durch den ersten Prozessor CN beschreibbaren Speicheradresse auszulesen, die ausgelesenen Wert zu verarbeiten und die Ergebnisse der Verarbeitung als Ausgangsdaten in einem Ausgangsdatenkanal OUT1, ..., OUT4 zu hinterlegen. Jede Sequenz SEQ1, ..., SEQ5 ist individuell und an die Erfordernisse der jeweiligen Task TSK1, ..., TSK3 angepasst, und jeder Schnittstellenprozessor ION1, ..., ION5 arbeitet die auf ihm hinterlegte Sequenz SEQ1, ..., SEQ5 sukzessive ab. Durch die parallele Abarbeitung der Sequenzen SEQ1, ..., SEQ5 auf mehreren Schnittstellenprozessoren ION1, ..., ION5 ist es zudem ausgeschlossen, dass die Abarbeitung einer Sequenz SEQ1, ..., SEQ5 zugunsten der Abarbeitung einer anderen Sequenz SEQ1, ..., SEQ5 einer höher priorisierten Task TSK1, ..., TSK3 unterbrochen wird. Auf diese Weise ist eine schnelle, d.h. zeitoptimierte, und jitterarme Abarbeitung der Sequenzen SEQ1, ..., SEQ5 sichergestellt.

## Patentansprüche

1. Verfahren zum Konfigurieren einer Schnittstelleneinheit (IO) eines Computersystems (HIL),
wobei das Computersystem (HIL) einen ersten Prozessor (CN) und eine erste Datenverbindung (DL1) zwischen dem ersten Prozessor (CN) und der Schnittstelleneinheit (IO) aufweist und auf der Schnittstelleneinheit (IO) ein zweiter Prozessor (ION1, ..., ION5) hinterlegt ist oder hinterlegt wird,
wobei die Schnittstelleneinheit (IO) mindestens zwei Datenkanäle (IN1, ..., IN4, OUT1, ..., OUT4) aufweist, wobei ein erster Eingangsdatenkanal (IN1, ..., IN4) als Datenkanal zum Hinterlegen von Eingangsdaten ausgestaltet ist und ein erster Ausgangsdatenkanal (OUT1, ..., OUT4) als Datenkanal zum Hinterlegen von Ausgangsdaten ausgestaltet ist,
wobei eine Peripherie (PER) des Computersystems (HIL) derart eingerichtet wird, dass die Peripherie (PER) eine Anzahl peripherer Geräte (THR, ECU, XB) umfasst und die Peripherie (PER) ausgestaltet ist, um mittels einer zweiten Datenverbindung (DL2) Eingangsdaten in dem ersten Eingangsdatenkanal (IN1, ..., IN4) zu hinterlegen oder Ausgangsdaten aus dem ersten Ausgangsdatenkanal (OUT1, ..., OUT4) auszulesen,
wobei die Schnittstelleneinheit (IO) ausgestaltet ist, um eine Datenverbindung zum Auslesen der in dem ersten Eingangsdatenkanal (IN1, ..., IN4) hinterlegten Eingangsdaten durch den zweiten Prozessor (ION1, ..., ION5) bereitzustellen und um eine Datenverbindung zum Hinterlegen von Ausgangsdaten in dem ersten Ausgangsdatenkanal (OUT1, ..., OUT4) durch den zweiten Prozessor (ION1, ..., ION5) bereitzustellen,
wobei auf dem Computersystem (HIL) ein Computerprogramm hinterlegt wird und der erste Prozessor (CN) programmiert wird, um das Computerprogramm abzuarbeiten und während der Abarbeitung des Computerprogramms einer Variablen des Computerprogramms einen Wert zuzuweisen, der durch die im ersten Eingangsdatenkanal (IN1, ..., IN4) hinterlegten Eingangsdaten definiert ist,
wobei vor Beginn der Abarbeitung des Computerprogramms durch den ersten Prozessor (CN) durch das Computersystem (HIL) eine Konfigurationsphase gestartet wird und während der Konfigurationsphase von dem Computersystem (HIL) eine Sequenz (SEQ1, ..., SEQ5) von Prozessorbefehlen erstellt und auf den zweiten Prozessor (ION1, ..., ION5) geladen wird,
nach dem Laden der Sequenz (SEQ1, ..., SEQ5) auf den zweiten Prozessor (ION1, ..., ION5) die Abarbeitung des Computerprogramms durch den ersten Prozessor (CN) und die Abarbeitung der Sequenz (SEQ1, ..., SEQ5) durch den zweiten Prozessor (ION1, ..., ION5) gestartet wird
und während der Abarbeitung der Sequenz (SEQ1, ..., SEQ5) der durch die im ersten Eingangsdatenkanal (IN1, ..., IN4) hinterlegten Daten definierte Wert an eine erste Speicheradresse geschrieben wird,
**dadurch gekennzeichnet, dass** von unterschiedlichen für den Datenaustausch mit der Peripherie eingerichteten Subroutinen des Computerprogramms eine Anzahl von Subsequenzen (SUB1, ..., SUB3) von Prozessorbefehlen erstellt wird,
wobei eine von einer ersten Subroutine erstellte erste Subsequenz (SUB1, ... SUB5) eine Routine zum Einlesen und Verarbeiten zumindest der in dem ersten Eingangsdatenkanal (IN1, ..., IN4) hinterlegten Daten darstellt
und eine von einer zweiten Subroutine erstellte zweite Subsequenz (SUB1, ..., SUB5) eine Routine zum Einlesen und Verarbeiten zumindest der in einem zweiten Eingangsdatenkanal (IN1, ..., IN4) hinterlegten Daten darstellt oder eine Routine zur Verarbeitung von durch den ersten Prozessor erzeugten Daten und zur Hinterlegung der verarbeiteten Daten in dem ersten Ausgangsdatenkanal (OUT1, ..., OUT4) darstellt,
und durch Zusammenfügen der Subsequenzen (SUB1, ..., SUB5) zu einer Folge von Subsequenzen die Sequenz (SEQ1, ..., SEQ5s) erstellt wird.

2. Verfahren nach Anspruch 1, wobei das Computerprogramm mindestens einen ersten I/O-Treiber (IOD1, ..., IOD8) und einen zweiten I/O-Treiber (IOD1, ..., IOD8) beinhaltet, wobei der erste I/O-Treiber (IOD1, ..., IOD8) die erste Subsequenz (SUB1, ..., SUB3) erstellt und der zweite I/O-Treiber (IOD1, ..., IOD8) die zweite Subsequenz (SUB1, ..., SUB3) erstellt.

3. Verfahren nach Anspruch 2, wobei vor Beginn der Abarbeitung des Computerprogramms eine Konfigurationsphase gestartet wird,
während der Konfigurationsphase eine Softwareinstanz die Sequenz (SEQ1, ..., SEQ5) erzeugt, wobei die Sequenz (SEQ1, ..., SEQ5) unmittelbar nach Erzeugung durch die Softwareinstanz leer ist
und der erste I/O-Treiber (IOD1, ..., IOD8) die erste Subsequenz (SUB1, ..., SUB3) in die Sequenz (SEQ1, ..., SEQ5) schreibt und der zweite I/O-Treiber (IOD1, ..., IOD8) die zweite Subsequenz (SUB1, ..., SUB3) in die Sequenz (SEQ1, ..., SEQ5) schreibt.

4. Verfahren nach einem der bisherigen Ansprüche, wobei die Sequenz (SEQ1, ..., SEQ5) vor dem Laden der Sequenz (SEQ1, ..., SEQ5) auf den zweiten Prozessor (ION1, ..., ION5) optimiert wird, insbesondere, dass redundante Befehle aus der Sequenz entfernt werden oder redundante Speicherzugriffe aus der Sequenz entfernt werden oder der Sequenz ein Prozessorbefehl zur Ausführung eines Strobes hinzugefügt wird.

5. Verfahren nach einem der vorhergehenden Ansprüche, wobei die Sequenz (SEQ1, ..., SEQ5) eine minimierte Anzahl an Sprunganweisungen, insbesondere keine Sprunganweisungen, beinhaltet oder die Sequenz (SEQ1, ..., SEQ5) keine Funktionsaufrufe beinhaltet.

6. Verfahren nach einem der vorhergehenden Ansprüche, wobei der zweite Prozessor (ION1, ..., ION5) eingerichtet ist oder eingerichtet wird, bei der Abarbeitung der Sequenz (SEQ1, ..., SEQ5) kein Caching anzuwenden.

7. Verfahren nach einem der vorhergehenden Ansprüche, wobei die Schnittstelleneinheit (IO) mindestens zwei zweite Prozessoren (ION1, ..., ION5) aufweist und für jeden zweiten Prozessor (ION1, ..., ION5) eine individuelle Sequenz (SEQ1, ..., SEQ5) erstellt wird.

8. Verfahren nach Anspruch 7, wobei die Schnittstelleneinheit (IO) ein FPGA aufweist und die zweiten Prozessoren (ION1, ..., ION5) als Softcores auf dem FPGA implementiert sind oder implementiert werden, insbesondere wobei die Softcores als Flow-Control-Prozessoren implementiert sind oder implementiert werden.

9. Verfahren nach einem der Ansprüche 7 oder 8, wobei das Computerprogramm mehr als eine Task (TSK1, ..., TSK3) beinhaltet und jeder zweite Prozessor (ION1, ..., ION5) eindeutig einer Task zugewiesen wird, wobei die auf einen bestimmten zweiten Prozessor (ION1, ..., ION5) geladene Sequenz (SEQ1, ..., SEQ5) nur Subsequenzen (SUB1, ..., SUB3) von I/O-Treibern (IOD1, ..., IOD8) der Task (TSK1, ..., TSK3) enthält, der der bestimmte Prozessor (ION1, ..., ION5) zugewiesen ist.

10. Verfahren nach Anspruch 9, wobei jeder Task (TSK1, ..., TSK3) mit mindestens einem I/O-Treiber (IOD1, ..., IOD5) eine Priorität zugewiesen wird und die zweiten Prozessoren (ION1, ..., ION5) bevorzugt der Task (TSK1, ..., TSK3) mit der höchsten Priorität zugewiesen werden.

11. Verfahren nach einem der vorhergehenden Ansprüche, wobei die Abarbeitung der Sequenz (SEQ1, ..., SEQ3) auf einem zweiten Prozessor (ION1, ..., ION5) durch ein Triggersignal gestartet wird, wobei das Triggersignal durch einen I/O-Treiber (IOD1, ..., ION8) oder durch einen Zeitgeber erzeugt wird.

12. Computersystem (HIL) mit einem ersten Prozessor (CN), einer Schnittstelleneinheit (IO) und einer Peripherie (PER),
wobei die Schnittstelleneinheit (IO) mindestens zwei Datenkanäle (IN1, ..., IN4, OUT1, ..., OUT4) aufweist, wobei ein erster Eingangsdatenkanal (IN1, ..., IN4) als Datenkanal zur Hinterlegung von Eingangsdaten in dem Eingangsdatenkanal (IN1, ..., IN4) durch die Peripherie (PER) eingerichtet ist und ein erster Ausgangsdatenkanal (OUT1, ..., OUT4) zur Hinterlegung von Ausgangsdaten für die Peripherie (PER) eingerichtet ist,
wobei die Schnittstelleneinheit (IO) einen zweiten Prozessor (ION1, ..., ION5) aufweist und die Schnittstelleneinheit (IO) ausgestaltet ist, um eine Datenverbindung zum Auslesen der in dem ersten Eingangsdatenkanal (IN1, ..., IN4) hinterlegten Eingangsdaten durch den zweiten Prozessor (ION1, ..., ION5) bereitzustellen und um eine Datenverbindung zum Hinterlegen von Ausgangsdaten in dem ersten Ausgangsdatenkanal (OUT1, ..., OUT4) durch den zweiten Prozessor (ION1, ..., ION5) bereitzustellen,
wobei das Computersystem (HIL) eine erste Datenverbindung (DL1) zwischen dem ersten Prozessor (CN) und und der Schnittstelleneinheit (IO) aufweist,
wobei die Peripherie (PER) des Computersystems (HIL) derart eingerichtet ist, dass die Peripherie (PER) eine Anzahl peripherer Geräte (THR, ECU, XB) umfasst und die Peripherie (PER) ausgestaltet ist, um mittels einer zweiten Datenverbindung (DL2) Eingangsdaten in dem ersten Eingangsdatenkanal (IN1, ..., IN4) zu hinterlegen oder Ausgangsdaten aus dem ersten Ausgangsdatenkanal (OUT1, ..., OUT4) auszulesen,
wobei auf dem Computersystem (HIL) ein Computerprogramm hinterlegt ist und das Computersystem (HIL) eingerichtet ist, um vor Beginn der Abarbeitung des Computerprogramms durch den ersten Prozessor (CN) eine Konfigurationsphase zu starten, während der Konfigurationsphase eine Sequenz (SEQ1, ..., SEQ5) von Prozessorbefehlen zu erstellen und die Sequenz (SEQ1, ..., SEQ5) auf den zweiten Prozessor (ION1, ..., ION5) zu laden,
nach dem Laden der Sequenz (SEQ1, ..., SEQ5) auf den zweiten Prozessor (ION1, ..., ION5) die Abarbeitung des Computerprogramms durch den ersten Prozessor (CN) und die Abarbeitung der Sequenz (SEQ1, ..., SEQ5) durch den zweiten Prozessor (ION1, ..., ION5) zu starten
und während der Abarbeitung der Sequenz (SEQ1, ..., SE Q5) den durch die im ersten Eingangsdatenkanal (IN1, ..., IN4) hinterlegten Daten definierten Wert an eine erste Speicheradresse zu schreiben,
wobei auf dem ersten Prozessor (CN) eine Anzahl von für den Datenaustausch mit der Peripherie eingerichteten Subroutinen des Computerprogramms hinterlegt ist,
**dadurch gekennzeichnet, dass** die Subroutinen eingerichtet sind, um während der Konfigurationsphase eine Anzahl von Subsequenzen (SUB1, ..., SUB3) von Prozessorbefehlen zu erstellen,
eine erste Subroutine (IOD1, ..., IOD8) eingerichtet ist, um während der Konfigurationsphase eine erste Subsequenz (SUB1, ..., SUB3) von Prozessorbefehlen zu erstellen, wobei die erste Subsequenz (SUB1, ..., SUB3) eine Routine zum Einlesen und Verarbeiten zumindest der in einem ersten Eingangsdatenkanal (IN1, ..., IN4) hinterlegten Daten darstellt,
eine zweite Subroutine (IOD1, ..., IOD8) eingerichtet ist, um während der Konfigurationsphase eine zweite Subsequenz (SUB1, ..., SUB3) von Prozessorbefehlen zu erstellen, wobei die zweite Subsequenz (SUB1, ..., SUB3) eine Routine zum Einlesen und Verarbeiten zumindest der in einem zweiten Eingangsdatenkanal (IN1, ..., IN4) hinterlegten Daten darstellt oder eine Routine zur Verarbeitung von durch den ersten Prozessor (CN) erzeugten Daten und zur Hinterlegung der verarbeiteten Daten in dem ersten Datenausgangskanal (OUT1, ..., OUT4) darstellt,
und das Computersystem (HIL) eingerichtet ist, um durch Zusammenfügen der Subsequenzen (SUB1, ..., SUB3) zu einer Folge von Subsequenzen die Sequenz (SEQ1, ..., SEQ5) zu erstellen.

13. Computersystem (HIL) nach Anspruch 12, wobei das Computersystem (HIL) ausgestaltet ist, um das Computerprogramm mittels des ersten Prozessors (CN) in harter Echtzeit abzuarbeiten, insbesondere wobei das Computersystem (HIL) als Hardware-in-the-Loop-Simulator oder als Rapid-Control-Prototyping-System ausgestaltet ist.

14. Computersystem nach Anspruch 12 oder 13, wobei das Computersystem (HIL) eingerichtet ist, die Sequenz (SEQ1, ..., SEQ5) mit einer minimierten Anzahl an Sprungbefehlen, insbesondere ohne Sprungbefehle, zu erstellen.

15. Computersystem nach einem der Ansprüche 12 bis 14, wobei der zweite Prozessor (ION1, ..., ION5) eingerichtet ist, bei der Abarbeitung der Sequenz (SEQ1, ..., SEQ5) kein Caching anzuwenden.

16. Computersystem (HIL) nach einem der Ansprüche 12 bis 15, wobei die Schnittstelleneinheit (IO) mindestens zwei zweite Prozessoren (ION1, ..., ION5) aufweist und das Computersystem (HIL) eingerichtet ist, für jeden zweiten Prozessor (ION1, ..., ION5) eine individuelle Sequenz (SEQ1, ..., SEQ5) zu erstellen und eine individuelle Sequenz (SEQ1, ..., SEQ5) auf jeden zweiten Prozessor (ION1, ..., ION5) zu laden.

## Claims

1. A method for configuring an interface unit (IO) of a computer system (HIL),
the computer system (HIL) comprising a first processor (CN) and a first data connection (DL1) between the first processor (CN) and the interface unit (IO) and a second processor (ION1, ..., ION5) being present or being placed on the interface unit (IO),
the interface unit (IO) comprising at least two data channels (IN1, ..., IN4, OUT1, ..., OUT4), a first input data channel (IN1, ..., IN4) being implemented as a data channel for storing input data and a first output data channel (OUT1, ..., OUT4) being implemented as a data channel for storing output data,
a periphery (PER) of the computer system (HIL) being set up such that the periphery (PER) comprises a plurality of peripheral devices (THR, ECU, XB) and the periphery (PER) is implemented for storing input data in the first input data channel (IN1, ..., IN4) or for reading output data from the first output data channel (OUT1, ..., OUT4) by means of a second data connection (DL2),
the interface unit (IO) being implemented for providing a data connection for the second processor (ION1, ..., ION5) to read the input data stored in the first input data channel (IN1, ..., IN4), and for providing a data connection for the second processor (ION1, ..., ION5) to store output data in the first output data channel (OUT1, ..., OUT4),
a computer program being stored on the computer system (HIL) and the first processor (CN) being programmed for running the computer program and for assigning a value defined by the input data stored in the first input data channel (IN1, ..., IN4) to a variable of the computer program while the computer program is running,
a configuration phase being started by the computer system (HIL) prior to the running of the computer program by the first processor (CN) being started, and a sequence (SEQ1, ..., SEQ5) of processor commands being created and loaded to the second processor (ION1, ..., ION5) by the computer system (HIL) during the configuration phase,
the running of the computer program by the first processor (CN) and the running of the sequence (SEQ1, ..., SEQ5) by the second processor (ION 1, ..., ION5) being started after loading the sequence (SEQ1, ..., SEQ5) to the second processor (ION1, ..., ION5),
and the value defined by the data stored in the first input data channel (IN1, ..., IN4) being written to a first memory address during the running of the sequence (SEQ1, ..., SEQ5),
**characterized in that** a plurality of subsequences (SUB1, ..., SUB3) are created by various subroutines of the computer program set up for data exchange with the periphery,
wherein a first subsequence (SUB1, ..., SUB5) created by a first subroutine is a routine for reading and processing of the data stored in the first input data channel (IN1, ..., IN4) and a second subsequence (SUB1, ..., SUB5) created by a second subroutine is a routine for reading and processing at least the data stored in a second input data channel (IN1, ..., IN4) or a routine for processing data generated by the first processor and for storing the processed data in the first output data channel (OUT1, ..., OUT4),
and the sequence (SEQ1, ..., SEQ5) is created by merging the subsequences (SUB1, ..., SUB5) into a series of subsequences.

2. The method according to claim 1, **characterized in that** the computer program comprises at least one first I/O driver (IOD1, ..., IOD8) and one second I/O driver (IOD1, ..., IOD8), wherein the first I/O driver (IOD1, ..., IOD8) creates the first subsequence (SUB1, ..., SUB3) and the second I/O driver (IOD1, ..., IOD8) creates the second subsequence (SUB1, ..., SUB3).

3. The method according to claim 2, **characterized in that** a configuration phase is started prior to the start of running the computer program,
that a software instance generates the sequence (SEQ1, ..., SEQ5) during the configuration phase, wherein the sequence (SEQ1, ..., SEQ5) is empty immediately after being created by the software instance,
and that the first I/O driver (IOD1, ..., IOD8) writes the first subsequence (SUB1, ..., SUB3) into the sequence (SEQ1, ...SEQ5) and the second I/O driver (IOD1, ..., IOD8) writes the second subsequence (SUB1, ..., SUB3) into the sequence (SEQ1, ...SEQ5).

4. The method according to any one of the preceding claims, **characterized in that** the sequence (SEQ1, ..., SEQ5) is optimized prior to loading the sequence (SEQ1, ..., SEQ5) to the second processor (ION1, ..., ION5), particularly **in that** redundant commands are removed from the sequence or redundant memory accesses are removed from the sequence or a processor command for executing a strobe is added to the sequence.

5. The method according to any one of the preceding claims, **characterized in that** the sequence (SEQ1, ..., SEQ5) comprises a minimized number of jump commands, particularly no jump commands, or the sequence (SEQ1, ..., SEQ5) comprises no function calls.

6. The method according to any one of the preceding claims, **characterized in that** the second processor (ION1, ..., ION5) is set up for applying no caching for the running of the sequence (SEQ1, ..., SEQ5).

7. The method according to any one of the preceding claims, **characterized in that** the interface unit (IO) comprises at least two second processors (ION1, ..., ION5) and one individual sequence (SEQ1, ..., SEQ5) is created for each second processor (ION1, ..., ION5).

8. The method according to claim 7, **characterized in that** the interface unit (IO) comprises an FPGA and the second processors (ION1, ..., ION5) are implemented as softcores on the FPGA, particularly **in that** the softcores are implemented as flow-control processors.

9. The method according to any one of the claims 7 or 8, **characterized in that** the computer program comprises more than one task (TSK1, ..., TSK3) and each second processor (ION1, ..., ION5) is uniquely assigned to one task, wherein the sequence (SEQ1, ..., SEQ5) loaded to a particular second processor (ION1, ..., ION5) comprises only subsequences (SUB1, ..., SUB3) of I/O drivers (IOD1, ..., IOD8) of the task the particular processor (ION1, ..., ION8) is assigned to.

10. The method according to claim 9, **characterized in that** each task (TSK1, ..., TSK3) with at least one I/O driver (IOD1, ..., IOD8) is assigned a priority and the second processors (ION1, ..., ION5) are preferably assigned to the task (TSK1, ..., TSK3) having the highest priority.

11. The method according to any one of the preceding claims, **characterized in that** the running of the sequence (SEQ1, ..., SEQ 3) on a second processor (ION1, ..., ION5) is started by a trigger signal, wherein the trigger signal is generated by an I/O driver (IOD1, ..., IOD8) or by a timer.

12. A computer system (HIL) having a first processor (CN), an interface unit (IO, and a periphery (PER),
the interface unit (IO) comprising at least two data channels (IN1, ..., IN4, OUT1, ..., OUT4), a first input data channel (IN1, ..., IN4) being set up as a data channel for the periphery (PER) to store input data in the first input data channel (IN1, ..., IN4) and a first output data channel (OUT1, ..., OUT4) being set up for the periphery (PER) to store output data,
the interface unit (IO) comprising a second processor (ION1, ..., ION5) and the interface unit (IO) being implemented for providing a data connection for the second processor (ION1, ..., ION5) to read the input data stored in the first input data channel (IN1, ..., IN4) and for providing a data connection for the second processor (ION1, ..., ION5) to store output data in the first output data channel (OUT1, ..., OUT4),
the computer system (HIL) comprising a first data connection (DL1) between the first processor (CN) and the interface unit (IO),
the periphery (PER) of the computer system (HIL) being set up such that the periphery (PER) comprises a plurality of peripheral devices (THR, ECU, XB) and the periphery (PER) is implemented for storing input data in the first input data channel (IN1, ..., IN4) or for reading output data from the first output data channel (OUT1, ..., OUT4) by means of a second data connection (DL2),
a computer program being stored on the computer system (HIL) and the computer system (HIL) being set up for starting a configuration phase prior to the running of the computer program by the first processor (CN) being started, for creating a sequence (SEQ1, ..., SEQ5) of processor commands during the configuration phase, and for loading the sequence (SEQ1, ..., SEQ5) to the second processor (ION1, ..., ION5),
the running of the computer program by the first processor (CN) and the running of the sequence (SEQ1, ..., SEQ5) by the second processor (ION 1, ..., ION5) being started after loading the sequence (SEQ1, ..., SEQ5) to the second processor (ION1, ..., ION5),
and for writing the value defined by the data stored in the first input data channel (IN1, ..., IN4) to a first memory address while the sequence (SEQ1, ..., SEQ5) is running,
a plurality of subroutines of the computer program set up for data exchange with the periphery being stored on the first processor (CN),
**characterized in that** the subroutines are set up for creating a plurality of subsequences (SUB1, ..., SUB3) of processor commands during the configuration phase,
a first subroutine (IOD1, ..., IOD8) is set up for creating a first subsequence (SUB1, ..., SUB3) of processor commands during the configuration phase, wherein the first subsequence (SUB1, ..., SUB3) is a routine for reading and processing at least the data stored in a first input data channel (IN1, ..., IN4), a second subroutine (IOD1, ..., IOD8) is set up for creating a second subsequence (SUB1, ..., SUB3) of processor commands during the configuration phase, wherein the second subsequence (SUB1, ..., SUB3) is a routine for reading and processing at least the data stored in a second input data channel (IN1, ..., IN4) or is a routine for processing data generated by the first processor (CN) and for storing the processed data in the first data output channel (OUT1, ..., OUT4),
and the computer system (HIL) is set up for creating the sequence (SEQ1, ..., SEQ5) by merging the subsequences (SUB1, ..., SUB5) into a series of subsequences.

13. The computer system (HIL) according to claim 12, **characterized in that** the computer system (HIL) is implemented for running the computer program by means of the first processor (CN) in hard real time, particularly **in that** the computer system (HIL) is implemented as a hardware-in-the-loop simulator or as a rapid-control-prototyping system.

14. The computer system according to claim 12 or 13, **characterized in that** the computer system (HIL) is set up for creating the sequence (SEQ1, ..., SEQ5) having a minimized number of jump commands, particularly having no jump commands.

15. The computer system according to any one of the claims 12 through 14, **characterized in that** the second processor (ION1, ..., ION5) is set up for applying no caching for the running of the sequence (SEQ1, ..., SEQ5).

16. The computer system (HIL) according to any one of the claims 12 through 15, **characterized in that** the interface unit (IO) comprises at least two second processors (ION1, ..., ION5) and the computer system (HIL) is set up for creating one individual sequence (SEQ1, ..., SEQ5) for each second processor (ION1, ..., ION5) and for loading one individual sequence (SEQ1, ..., SEQ5) to each second processor (ION1, ..., ION5).

## Revendications

1. Procédé pour configurer une unité d'interface (IO) d'un système d'ordinateur (HIL),
sachant que le système d'ordinateur (HIL) comporte un premier processeur (CN) et une première connexion de données (DL1) entre le premier processeur (CN) et l'unité d'interface (IO) et un second processeur (ION1, ..., ION5) est stocké sur l'unité d'interface (IO),
sachant que l'unité d'interface (IO) comporte au moins deux voies de données (IN1, ..., IN4, OUT1, ..., OUT4), sachant qu'une première voie d'entrée de données (IN1, ..., IN4) est configurée en tant que voie de données pour stocker des données d'entrée et une première voie de sortie de données (OUT1, ..., OUT4) est configurée en tant que voie de données pour stocker des données de sortie,
sachant qu'une périphérie (PER) du système d'ordinateur (HIL) est configurée de sorte que la périphérie (PER) comprenne un certain nombre d'appareils périphériques (THR, ECU, XB) et la périphérie (PER) est configurée pour, à l'aide d'une seconde connexion de données (DL2), stocker des données d'entrée dans la première voie d'entrée de données (IN1, ..., IN4) ou lire des données de sortie depuis la première voie de sortie de données (OUT1, ..., OUT4),
sachant que l'unité d'interface (IO) est configurée pour fournir une connexion de données permettant la lecture, par le second processeur (ION1, ..., ION5), des données d'entrée stockées dans la première voie d'entrée de données (IN1, ..., IN4) et pour fournir une connexion de données permettant de stocker, par le second processeur (ION1, ..., ION5), des données de sortie dans la première voie de sortie de données (OUT1, ..., OUT4),
sachant qu'un programme informatique est enregistré sur le système d'ordinateur (HIL) et le premier processeur (CN) est programmé pour exécuter le programme informatique et, durant l'exécution du programme informatique, attribuer à une variable du programme informatique une valeur qui est définie par les données d'entrée stockées dans la première voie d'entrée de données (IN1, ..., IN4),
sachant qu'avant le début de l'exécution du programme informatique par le premier processeur (CN), une phase de configuration est démarrée par le système d'ordinateur (HIL) et, durant la phase de configuration, une séquence (SEQ1, ..., SEQ5) d'instructions de processeur est créée par le système d'ordinateur (HIL) et chargée sur le second processeur (ION1, ..., ION5),
après le chargement de la séquence (SEQ1, ..., SEQ5) sur le second processeur (ION1, ..., ION5), l'exécution du programme informatique par le premier processeur (CN) et l'exécution de la séquence (SEQ1,..., SEQ5) par le second processeur (ION1, ..., ION5) démarrent
et, durant l'exécution de la séquence (SEQ1, ..., SEQ5), la valeur définie par les données stockées dans la première voie d'entrée de données (IN1, ..., IN4) est écrite à une première adresse en mémoire,
**caractérisé en ce qu'**un certain nombre de sous-séquences (SUB1, ..., SUB3) d'instructions de processeur est créé par différentes sous-routines du programme informatique configurées pour l'échange de données avec la périphérie,
sachant qu'une première sous-séquence (SUB1, ... SUB5) créée par une première sous-routine représente une routine pour lire et traiter au moins les données stockées dans la première voie d'entrée de données (IN1, ..., IN4),
et une seconde sous-séquence (SUB1, ..., SUB5) créée par une seconde sous-routine représente une routine pour lire et traiter au moins les données stockées dans une seconde voie d'entrée de données (IN1, ..., IN4) ou une routine pour le traitement des données créées par le premier processeur et pour le stockage des données traitées dans la première voie de sortie de données (OUT1, ..., OUT4),
et la séquence (SEQ1, ..., SEQ5s) est créée par consolidation des sous-séquences (SUB1, ..., SUB5) en une chaîne de sous-séquences.

2. Procédé selon la revendication 1, dans lequel le programme informatique comporte au moins un premier pilote I/O (IOD1, ..., IOD8) et un second pilote I/O (IOD1, ..., IOD8), sachant que le premier pilote I/O (IOD1, ..., IOD8) crée la première sous-séquence (SUB1, ..., SUB3) et le second pilote I/O (IOD1, ..., IOD18) crée la seconde sous-séquence (SUB1, ..., SUB3).

3. Procédé selon la revendication 2, dans lequel une phase de configuration est démarrée avant le début de l'exécution du programme informatique,
durant la phase de configuration, une instance du logiciel crée la séquence (SEQ1, ..., SEQ5), sachant que la séquence (SEQ1, ..., SEQ5) est vide immédiatement après la création par l'instance du logiciel
et le premier pilote I/O (IOD1, ..., IOD5) écrit la première sous-séquence (SUB1, ..., SUB3) dans la séquence (SEQ1, ..., SEQ5) et le second pilote I/O (IOD1, ..., IOD5) écrit la seconde sous-séquence (SUB1, ..., SUB3) dans la séquence (SEQ1, ..., SEQ5).

4. Procédé selon l'une des revendications précédentes, dans lequel la séquence (SEQ1, ..., SEQ5) est optimisée avant le chargement de la séquence (SEQ1, ..., SEQ5) sur le second processeur (ION1, ..., ION5), en particulier, les instructions redondantes sont supprimées de la séquence ou les accès à la mémoire sont supprimés de la séquence ou une instruction de processeur est ajoutée à la séquence pour l'exécution d'un échantillonnage.

5. Procédé selon l'une des revendications précédentes, dans lequel la séquence (SEQ1, ..., SEQ5) contient un nombre minimalisé d'instructions de saut, en particulier, ne contient aucune instruction de saut, ou la séquence (SEQ1, ..., SEQ5) ne contient aucun appel de fonction.

6. Procédé selon l'une des revendications précédentes, dans lequel le second processeur (ION1, ..., ION5) est configuré pour ne pas utiliser de mise en antémémoire (caching) lors de l'exécution de la séquence (SEQ1, ..., SEQ5).

7. Procédé selon l'une des revendications précédentes, dans lequel l'unité d'interface (IO) comporte au moins deux seconds processeurs (ION1, ..., ION5) et une séquence individuelle (SEQ1, ..., SEQ5) est créée pour chaque second processeur (ION1, ..., ION5).

8. Procédé selon la revendication 7, dans lequel l'unité d'interface (IO) comporte un réseau de portes programmables (FPGA) et les seconds processeurs (ION1, ..., ION5) sont implémentés en tant que coeurs de processeur logiciel (softcores) sur le FPGA, en particulier, dans lequel les coeurs de processeur logiciel sont implémentés en tant que processeurs de régulation de flux.

9. Procédé selon l'une des revendications 7 ou 8, dans lequel le programme informatique contient plus d'une tâche (TSK1, ..., TSK3) et chaque second processeur (ION1, ..., ION5) est univoquement attribué à une tâche, sachant que la séquence (SEQ1, ..., SEQ5) chargée sur un second processeur (ION1, ..., ION5) déterminé ne contient que des sous-séquences (SUB1, ..., SUB3) de pilotes I/O (IOD1, ..., IOD8) de la tâche (TSK1, ..., TSK3), à laquelle est attribué le processeur (ION1, ..., ION5) déterminé.

10. Procédé selon la revendication 9, dans lequel une priorité est attribuée à chaque tâche (TSK1, ..., TSK3) avec au moins un pilote I/O (IOD1, ..., IOD5) et les seconds processeurs (ION1, ..., ION5) sont attribués de préférence à la tâche (TSK1, ..., TSK3) avec la plus haute priorité.

11. Procédé selon l'une des revendications précédentes, dans lequel l'exécution de la séquence (SEQ1, ..., SEQ3) sur un second processeur (ION1, ..., ION5) est démarrée par un signal de déclenchement, sachant que le signal de déclenchement est généré par un pilote I/O (IOD1, ..., ION5) ou par un générateur de rythme.

12. Système d'ordinateur (HIL) avec un premier processeur (CN), une unité d'interface (IO) et une périphérie (PER),
sachant que l'unité d'interface (IO) comporte au moins deux voies de données (IN1, ..., IN4, OUT1, ..., OUT4), sachant qu'une première voie d'entrée de données (IN1, ..., IN4) est configurée en tant que voie de données pour stocker des données d'entrée dans la voie d'entrée de données (IN1, ..., IN4) via la périphérie (PER) et une première voie de sortie de données (OUT1, ..., OUT4) est configurée pour stocker des données de sortie pour la périphérie (PER),
sachant que l'unité d'interface (IO) comporte un second processeur (ION1, ..., ION5) et l'unité d'interface (IO) est configurée pour fournir une connexion de données permettant la lecture, par le second processeur (ION1, ..., ION5), des données d'entrée stockées dans la première voie d'entrée de données (IN1, ..., IN4) et pour fournir une connexion de données permettant de stocker, par le second processeur (ION1, ..., ION5), des données de sortie dans la première voie de sortie de données (OUT1, ..., OUT4),
sachant que le système d'ordinateur (HIL) comporte une première connexion de données (DL1) entre le premier processeur (CN) et l'unité d'interface (IO),
sachant que la périphérie (PER) du système d'ordinateur (HIL) est configurée de sorte que la périphérie (PER) comprenne un certain nombre d'appareils périphériques (THR, ECU, XB) et la périphérie (PER) est configurée pour, à l'aide d'une seconde connexion de données (DL2), stocker des données d'entrée dans la première voie d'entrée de données (IN1, ..., IN4) ou lire des données de sortie depuis la première voie de sortie de données (OUT1, ..., OUT4),
sachant qu'un programme informatique est enregistré sur le système d'ordinateur (HIL) et le système d'ordinateur (HIL) est configuré pour, avant le début de l'exécution du programme informatique par le premier processeur (CN), démarrer une phase de configuration, durant la phase de configuration, créer une séquence (SEQ1, ..., SEQ5) d'instructions de processeur et charger la séquence (SEQ1, ..., SEQ5) sur le second processeur (ION1, ..., ION5),
après le chargement de la séquence (SEQ1, ..., SEQ5) sur le second processeur (ION1, ..., ION5), démarrer l'exécution du programme informatique par le premier processeur (CN) et l'exécution de la séquence (SEQ1,..., SEQ5) par le second processeur (ION1, ..., ION5)
et, durant l'exécution de la séquence (SEQ1, ..., SEQ5), écrire à une première adresse en mémoire la valeur définie par les données stockées dans la première voie d'entrée de données (IN1, ..., IN4),
sachant qu'un certain nombre de sous-routines du programme informatique configurées pour l'échange de données avec la périphérie est stocké sur le premier processeur (CN),
**caractérisée en ce que** les sous-routines sont configurées pour, durant la phase de configuration, créer un certain nombre de sous-séquences (SUB1, ..., SUB3) d'instructions de processeur,
une première sous-routine (IOD1, ..., IOD8) est configurée pour, durant la phase de configuration, créer une première sous-séquence (SUB1, ..., SUB3) d'instructions de processeur, sachant que la première sous-séquence (SUB1, ..., SUB3) représente une routine pour lire et traiter au moins les données stockées dans une première voie d'entrée de données (IN1, ..., IN4),
et une seconde sous-routine (IOD1, ..., IOD8) est configurée pour, durant la phase de configuration, créer une seconde sous-séquence (SUB1, ..., SUB3) d'instructions de processeur, sachant que la seconde sous-séquence (SUB1, ..., SUB3) représente une routine pour lire et traiter au moins les données stockées dans une seconde voie d'entrée de données (IN1, ..., IN4) ou une routine pour le traitement des données créées par le premier processeur (CN) et pour le stockage des données traitées dans la première voie de sortie de données (OUT1, ..., OUT4),
et le système d'ordinateur (HIL) est configuré pour créer la séquence (SEQ1, ..., SEQ5) par consolidation des sous-séquences (SUB1, ..., SUB3) en une chaîne de sous-séquences.

13. Système d'ordinateur (HIL) selon la revendication 12, dans lequel le système d'ordinateur (HIL) se présente sous une forme pour exécuter le programme informatique à l'aide du premier processeur (CN) en temps réel strict, en particulier, dans lequel le système d'ordinateur (HIL) se présente sous la forme d'un simulateur « matériel dans la boucle » ou d'un système de type « Rapid Control Prototyping ».

14. Système d'ordinateur selon la revendication 12 ou 13, dans lequel le système d'ordinateur (HIL) est configuré pour créer la séquence (SEQ1, ..., SEQ5) avec un nombre minimisé d'instructions de saut, en particulier, sans instruction de saut.

15. Système d'ordinateur selon l'une des revendications 12 à 14, dans lequel le second processeur (ION1, ..., ION5) est configuré pour ne pas utiliser de mise en antémémoire (caching) lors de l'exécution de la séquence (SEQ1, ..., SEQ5).

16. Système d'ordinateur (HIL) selon l'une des revendications 12 à 15, dans lequel l'unité d'interface (IO) comporte au moins deux seconds processeurs (ION1, ..., ION5) et le système d'ordinateur (HIL) est configuré pour créer une séquence individuelle (SEQ1, ..., SEQ5) pour chaque second processeur (ION1, ..., ION5) et charger une séquence individuelle (SEQ1, ..., SEQ5) sur chaque second processeur (ION1, ..., ION5).
